# EUROPÄISCHE PATENTSCHRIFT

(11) **EP 2 602 798 B1**
(45) Veröffentlichungstag und Bekanntmachung des Hinweises auf die Patenterteilung: **22.01.2020**
(21) Anmeldenummer: 12008144.3
(22) Anmeldetag: 05.12.2012
(51) Int. Cl.: H01C 1/084, G01R 1/20, H01C 1/14

(54) **Strommesswiderstand**
current-measurement resistor
résistance de mesure du courant

(30) Priorität: 05.12.2011 DE 102011120276; 21.12.2011 DE 102011121902
(43) Veröffentlichungstag der Anmeldung: 12.06.2013
(73) Patentinhaber: Isabellenhütte Heusler GmbH & Co.KG, 35683 Dillenburg (DE)
(72) Erfinder: Hetzler, Ullrich, 35688 Dillenburg-Oberscheld (DE)
(74) Vertreter: Heusler, Wolfgang

(56) Entgegenhaltungen:
- EP-A1- 0 445 048
- DE-A1-102010 028 088
- JP-A- 8 186 011
- US-A- 4 494 068
- US-A1- 2003 020 592

## Beschreibung

Die Erfindung betrifft einen Widerstand, insbesondere einen Strommesswiderstand zur Messung eines elektrischen Stroms.

Ein derartiger Strommesswiderstand ist beispielsweise aus EP 0 605 800 A1 bekannt und besteht aus zwei plattenförmigen Anschlussteilen aus einem elektrisch leitfähigen Leitermaterial (z.B. Kupfer) und einem zwischen die beiden Anschlussteile eingesetzten, ebenfalls plattenförmigen Widerstandselement aus einem niederohmigen Widerstandsmaterial (z.B. Manganin®). Der zu messende elektrische Strom wird über die beiden Anschlussteile in den Strommesswiderstand eingeführt bzw. von dem Widerstand abgeführt und fließt durch das niederohmige Widerstandselement, so dass der Spannungsabfall über dem niederohmigen Widerstandselement entsprechend dem Ohmschen Gesetz ein Maß für den elektrischen Strom bildet.

Dieser bekannte Strommesswiderstand kann beispielsweise auf einer Platine montiert werden, die zur Kontaktierung des Strommesswiderstands vier Kontaktierungsflächen ("pads") aufweist, wobei zwei der Kontaktierungsflächen zum Einspeisen bzw. Abführen des zu messenden elektrischen Stroms dienen, während die beiden anderen Kontaktierungsflächen Spannungsabgriffe bilden, um die über dem Widerstandselement abfallende elektrische Spannung zu messen. Problematisch an dieser konstruktiven Gestaltung der Spannungsabgriffe ist zunächst die thermische und mechanische Kopplung zwischen dem Strommesswiderstand und der auf der Platine befindlichen Messschaltung. Ein weiterer Nachteil dieser konstruktiven Gestaltung der Spannungsabgriffe besteht darin, dass die Leiterschleife zwischen den Spannungsabgriffen und der Messschaltung eine relativ große Fläche aufspannt und damit eine Antenne bildet, die für Störstrahlungen empfindlich ist.

Eine andere konstruktive Gestaltung der Spannungsabgriffe ist aus DE 199 06 276 A1 bekannt. Hierbei wird die Messschaltung (z.B. ASIC: Application Specific Integrated Circuit) direkt auf dem Strommesswiderstand montiert. Diese konstruktive Gestaltung der Spannungsabgriffe ist jedoch ebenfalls mit einer mechanischen und thermischen Kopplung zwischen dem Strommesswiderstand und der Messschaltung verbunden.

Ferner ist zum Stand der Technik hinzuweisen auf DE 102 12 784 A1, DE 101 45 828 A1, DE 103 10 503 A1 und DE 10 2009 031 408 A1.

US 2003/0020592 A1 offenbart einen Widerstand gemäß dem Oberbegriff von Anspruch 1. Allerdings werden die Messleitungen zur Messung des Spannungsabfalls über dem Widerstandselement hierbei in entgegengesetzten Richtungen quer zur Stromflussrichtung nach außen geführt. Darüber hinaus werden die Messleitungen hierbei auf gegenüberliegenden Seiten der Leiterplatte geführt, auf der der Widerstand montiert ist. Dies hat beides zur Folge, dass die von den Messleitungen aufgespannte Fläche relativ groß ist, was zu einer unbefriedigenden Störempfindlichkeit führt.

Zum Stand der Technik ist ferner auch hinzuweisen auf EP 0 445 048 A1 und JP 8 186011 A.

Bei den bekannten Strommesswiderständen ist die Störempfindlichkeit jedoch unbefriedigend.

Der Erfindung liegt deshalb die Aufgabe zugrunde, einen entsprechend verbesserten Strommesswiderstand zu schaffen.

Diese Aufgabe wird durch einen erfindungsgemäßen Widerstand gemäß dem Hauptanspruch gelöst.

Die Erfindung sieht zunächst in Übereinstimmung mit dem Stand der Technik vor, dass der Widerstand zwei Anschlussteile aufweist, um den zu messenden elektrischen Strom in den Widerstand einzuleiten bzw. von dem Widerstand abzuführen. Die beiden Anschlussteile bestehen deshalb aus einem elektrisch leitfähigen Leitermaterial (z.B. Kupfer oder eine Kupferlegierung), um die Messung nicht durch die über den Anschlussteilen abfallende elektrische Spannung zu verfälschen.

In dem bevorzugten Ausführungsbeispiel der Erfindung sind die Anschlussteile plattenförmig, wie es beispielsweise auch aus der eingangs zitierten Patentanmeldung EP 0 605 800 A1 bekannt ist. Die plattenförmigen Anschlussteile können hierbei wahlweise eben oder gebogen sein, wobei eine gebogene Ausführung der Anschlussteile beispielsweise sinnvoll sein kann, damit das Widerstandselement durch einen Luftspalt von der darunter oder darüber befindlichen Platine mit der Messelektronik getrennt ist, was zu einer besseren passiven Kühlung des Widerstandselements bzw. thermischer Entkopplung führt und dadurch zur Verbesserung der Messgenauigkeit beiträgt.

Darüber hinaus weist der erfindungsgemäße Widerstand in Übereinstimmung mit dem Stand der Technik ein Widerstandselement auf, das aus einem niederohmigen Widerstandsmaterial (z.B. Manganin®) besteht, dessen spezifischer elektrischer Widerstand jedoch größer ist als der spezifische elektrische Widerstand des Leitermaterials der beiden Anschlussteile. Das Widerstandselement ist elektrisch zwischen die beiden Anschlussteile eingesetzt, so dass der elektrische Strom durch das Widerstandselement fließt. Anstelle von Manganin® (CuMn12Ni) können im Rahmen der Erfindung auch andere Widerstandsmaterialien eingesetzt werden, wie beispielsweise Nickel-Chrom-Legierungen (z.B. NiCr20AISi, NiCr6015, NiCr8020, NiCr3020), Kupfer-Mangan-Nickel-Legierungen (z.B. CuNi30Mn, CuNi23Mn) oder Kupfer-Nickel-Legierungen (z.B. CuNi15, Cu-Ni10, CuNi6, CuNi2).

Weiterhin verfügt der erfindungsgemäße Widerstand über zwei Spannungsabgriffe an den beiden Anschlussteilen, um die über dem Widerstandselement abfallende elektrische Spannung zu messen, da diese Spannung entsprechend dem Ohmschen Gesetz ein Maß für den durch den Widerstand fließenden elektrischen Strom bildet.

Die beiden Spannungsabgriffe sind mit zwei Messleitungen verbunden, die an eine entsprechende Messschaltung angeschlossen werden können, um die über dem Widerstandselement abfallende elektrische Spannung zu messen.

Im Gegensatz zu dem eingangs beschriebenen Stand der Technik sind diese beiden Messleitungen jedoch vorzugsweise zumindest auf einem Teil ihrer Länge als sogenannte flexible Leiterplatte (im Folgenden Flexleitung genannt) ausgebildet, wobei die Flexleitung vorzugsweise zumindest auf einem Teil ihrer Länge fest mit dem Widerstand verbunden ist.

Gemäß der Erfindung sind die Messleitungen als Leiterbahnen auf einem flexiblen Folienträger ausgebildet, wobei der Folienträger auch Kontaktierungsflächen trägt zur elektrischen Kontaktierung der beiden Anschlussteile des erfindungsgemäßen Widerstands, wobei die Leiterbahnen auf dem Folienträger mit diesen Kontaktierungsflächen verbunden sind.

Hierbei sind die beiden Messleitungen zur Kontaktierung der beiden Anschlussteile des Widerstands auf gegenüberliegenden Seiten des Folienträgers angeordnet.

Weiterhin besteht im Rahmen der Erfindung die Möglichkeit, dass auf dem Folienträger eine zusätzliche Masseleitung ausgebildet ist, die aus einer Leiterbahn auf dem Folienträger besteht und zur elektrischen Erdung des Widerstands dient, wobei die Masseleitung vorzugsweise mit einem der beiden Anschlussteile verbunden ist. Für spezielle Anwendungen (z.B. der Anschluss eines Temperatursensors auf einem Anschlussteil oder auf dem Widerstandselement) sind Ausführungen mit weiteren Leiterbahnen denkbar.

Vorteilhaft an der Verwendung eines Folienträgers zur konstruktiven Gestaltung der Spannungsabgriffe ist die Tatsache, dass die Spannungsabgriffe durch ein einziges Bauteil realisiert werden können. Der Folienträger kann also mit den darauf aufgebrachten Leiterbahnen und Kontaktierungsflächen in herkömmlicher Weise hergestellt werden und muss dann lediglich mit dem Widerstand verbunden werden.

Es wurde bereits vorstehend zum Stand der Technik erwähnt, dass die Messleitungen zwischen den Spannungsabgriffen und der Messschaltung eine Leiterschleife bilden, die eine Fläche aufspannt und dadurch eine Antenne zum Empfang von Störstrahlung bildet. Die erfindungsgemäße konstruktive Gestaltung der Messleitungen ermöglicht vorteilhaft eine äußerst geringe Fläche der von den Messleitungen aufgespannten Leiterschleife, so dass der erfindungsgemäße Widerstand gegenüber Störstrahlung wesentlich weniger empfindlich ist als herkömmliche Widerstände. Die von der Leiterschleife aufgespannte Fläche ist bei dem erfindungsgemäßen Widerstand vorzugsweise kleiner als 1 cm², 0,3 cm², 0,2 cm² oder sogar kleiner als 0,1 cm².

Zur Ermöglichung einer derart kleinen Fläche der von den Messleitungen aufgespannten Leiterschleife werden die Messleitungen von den außen liegenden Spannungsabgriffen zunächst nach innen zu einem Anschlusspunkt bzw. Anschlussbereich geführt, von wo die Messleitungen dann in einem gemeinsamen Kabelstrang nach außen geführt werden. Die beiden Messleitungen werden also von den Spannungsabgriffen ausgehend zunächst auf kürzestem Weg zu einem gemeinsamen Kabelstrang zusammengeführt, um die von der Leiterschleife der Messleitung aufgespannte Fläche zu minimieren.

Hierbei sind die Messleitungen und der gemeinsame Kabelstrang als Leiterbahnen auf dem flexiblen Folienträger ausgebildet, wie vorstehend beschrieben wurde.

Zwischen den Spannungsabgriffen und dem Anschlusspunkt verlaufen die Messleitungen parallel zur Hauptstromflussrichtung in dem Widerstandselement. Der gemeinsame Kabelstrang mit den darin befindlichen beiden Messleitungen wird dagegen von dem Anschlusspunkt ausgehend quer, insbesondere rechtwinklig, zur Hauptstromflussrichtung in dem Widerstandselement nach außen geführt.

Weiterhin ist zu erwähnen, dass die beiden Messleitungen und/oder der gemeinsame Kabelstrang mit den beiden Messleitungen auf der Oberfläche des Widerstandselements befestigt sein kann, insbesondere zwischen den außen liegenden Spannungsabgriffen und dem innen liegenden Anschlusspunkt (Verbindungspunkt) bzw. Anschlussbereich, und vorzugsweise parallel zur Oberfläche des Widerstandselements verläuft.

Die beiden Spannungsabgriffe zur Messung der über dem Widerstandselement abfallenden elektrischen Spannung sind vorzugsweise direkt an der Kante zwischen den Anschlussteilen und dem Widerstandselement angeordnet, um zu vermeiden, dass die Messung der über dem Widerstandselement abfallenden Spannung durch Spannungsabfälle innerhalb der Anschlussteile verfälscht wird.

Darüber hinaus sind die beiden Spannungsabgriffe vorzugsweise mittig an dem jeweiligen Anschlussteil angebracht, d.h. in der Mitte zwischen den parallel zur Hauptstromflussrichtung verlaufenden beiden Seitenkanten des jeweiligen Anschlussteils.

Die Befestigung der beiden Spannungsabgriffe an den Anschlussteilen kann beispielsweise durch eine Lötverbindung erfolgen, insbesondere durch das sogenannte Reflow-Löten. Alternativ besteht jedoch auch die Möglichkeit, die Spannungsabgriffe durch eine Schweißverbindung an den Anschlussteilen zu befestigen. Ferner besteht sogar die Möglichkeit, die Spannungsabgriffe durch eine elektrisch leitfähige Klebeverbindung an den Anschlussteilen anzubringen.

Weiterhin besteht im Rahmen der Erfindung die Möglichkeit, dass die Erwärmung des Widerstandselements durch eine Wärmesenke minimiert wird, die elektrisch von dem Widerstandselement isoliert ist, aber thermisch und physisch mit dem Widerstandselement verbunden wird. Die in dem Widerstandselement entstehende elektrische Verlustwärme wird dann zumindest teilweise von der Wärmesenke aufgenommen und abgeführt, was insbesondere in einem Kurzschlussfall wichtig ist, da dann eine erhebliche elektrische Verlustwärme in dem Widerstandselement entsteht.

Die Wärmesenke besteht aus einem Wärmesenkenmaterial, das vorzugsweise eine größere spezifische Wärmekapazität aufweist als das Leitermaterial der Anschlussteile und/oder als das Widerstandsmaterial des Widerstandselements. Beispielsweise kann die spezifische Wärmekapazität des Wärmesenkenmaterials im Rahmen der Erfindung größer sein als 400 J/kg·K, 600 J/kg·K oder 800 J/kg·K. Ferner ist zu erwähnen, dass die Wärmesenke vorzugsweise eine wesentlich größere Wärmekapazität aufweist als das Widerstandsmaterial, beispielsweise um einen Faktor von mindestens 10, 20 oder mindestens 30. Die Wärmekapazität der Wärmesenke lässt sich jedoch nicht nur durch die Auswahl eines geeigneten Wärmesenkenmaterial mit einer großen spezifischen Wärmekapazität erhöhen, sondern auch durch die Verwendung einer Wärmesenke mit einem möglichst großen Bauvolumen und/oder einer möglichst großen Masse. Die Wärmesenke weist deshalb vorzugsweise eine wesentlich größere Masse und/oder ein wesentlich größeres Bauvolumen auf als das Widerstandselement.

Neben einer möglichst großen Wärmekapazität der Wärmesenke ist es jedoch auch wichtig, dass die Wärmesenke eine möglichst gute Wärmeleitfähigkeit aufweist, um die in dem Widerstandselement entstehende elektrische Verlustwärme möglichst gut aufzunehmen und an die Umgebung abzuführen. Das Wärmesenkenmaterial weist deshalb vorzugsweise eine spezifische Wärmeleitfähigkeit von mehr als 100 W/m·K, 150 W/m·K oder 200 W/m·K auf. Beispielsweise kann die Wärmesenke aus Aluminium oder Aluminiumlegierung oder aus einem mit Aluminium-Kupfer plattierten Material bestehen.

In dem bevorzugten Ausführungsbeispiel der Erfindung weist die Wärmesenke ein Oberteil und ein Unterteil auf, die das Widerstandselement oben bzw. unten thermisch und physisch kontaktieren, wobei die Wärmesenke das Widerstandselement vorzugsweise auf seiner gesamten Fläche berührt, um einen möglichst guten Wärmeübergang von dem Widerstandselement auf die Wärmesenke zu erreichen.

Weiterhin ist zu erwähnen, dass die Wärmesenke in der Regel aus einem Material besteht, das nicht nur thermisch leitfähig ist, sondern auch elektrisch, was die Gefahr von Kurzschlüssen über dem Widerstand in sich birgt. Die Wärmesenke weist deshalb vorzugsweise eine elektrisch isolierende Oberflächenschicht auf, beispielsweise eine eloxierte Oxidschicht.

Zur Verbesserung des Wärmeübergangs von dem Widerstandselement auf die Wärmesenke kann zwischen der Wärmesenke und dem Widerstandselement ein Wärmeleitmittel angeordnet werden, insbesondere eine Wärmeleitpaste oder eine dünne Keramikschicht.

Weiterhin ist zu erwähnen, dass zur Verbesserung des Wärmeflusses vom Kühlkörper zu einem Anschlussteil (z.B. Massepunkt) ein oder beide Wärmesenken über das Anschlussteil geführt werden können, wobei ein einseitiger Kurzschluss zwischen Wärmesenke und Anschlussteil in Kauf genommen werden kann.

Ferner ist zu erwähnen, dass das Widerstandselement in der Mitte zwischen den beiden Anschlussteilen einen größeren Stromflussquerschnitt aufweisen kann als außen an den Kontaktstellen zu den Anschlussteilen. Dies ist vorteilhaft, weil dann der Ohmsche Widerstand in der Mitte zwischen den beiden Anschlussteilen wesentlich kleiner ist, so dass dort dann auch weniger thermische Verlustleistung entsteht. Dies ist wiederum sinnvoll, weil die Abführung der thermischen Verlustleistung über die Anschlussteile erfolgt, so dass in der Nähe der Anschlussteile eine höhere Verlustleistung entstehen kann als in der Mitte zwischen den beiden Anschlussteilen.

Darüber hinaus ist zu erwähnen, dass das Widerstandselement selbst wesentlich dünner sein kann als die Anschlussteile. Es besteht jedoch alternativ auch die Möglichkeit, dass die Anschlussteile dieselbe Dicke aufweisen wie das Widerstandselement.

Vorzugsweise wird im Rahmen der Erfindung ein Widerstandsmaterial verwendet, das gegenüber dem Leitermaterial (z.B. Kupfer) nur eine geringe Thermospannung aufweist. Dies ist vorteilhaft, da die Strommessung dann kaum durch Thermospannungen verfälscht wird. Vorzugsweise zeigt das Widerstandsmaterial deshalb in der Thermoelektrischen Spannungsreihe gegenüber Kupfer eine Thermospannung von weniger als 1 mV/100K, 0,5 mV/100K oder sogar weniger als 0,2 mV/100K.

Hierbei ist zu erwähnen, dass das Widerstandsmaterial im Vergleich zum Material der Anschlussteile hochohmig ist und einen spezifischen elektrischen Widerstand aufweist, der vorzugsweise größer ist als 10⁻⁵ Ω·m, 5·10⁻⁵ Ω·m oder sogar größer als 10⁻⁴ Ω·m.

Für eine möglichst temperaturkonstante Messung ist es weiterhin vorteilhaft, wenn das Widerstandsmaterial einen spezifischen elektrischen Widerstand mit einem möglichst kleinen linearen Temperaturkoeffizienten aufweist. Bei dem erfindungsgemäßen Widerstand ist der Temperaturkoeffizient des Widerstandsmaterials deshalb vorzugsweise kleiner als 5·10⁻⁴ K⁻¹, 2·10⁻⁴ K⁻¹, 10⁻⁴ K⁻¹ oder sogar kleiner als 5·10⁻⁵ K⁻¹.

Schließlich ist zu erwähnen, dass die Erfindung nicht auf den vorstehend beschriebenen Widerstand als einzelnes Bauteil beschränkt ist. Vielmehr umfasst die Erfindung auch eine komplette Messanordnung zur Strommessung mit einem derartigen Widerstand und einer damit verbundenen Messschaltung zur Messung der über dem Widerstand abfallenden elektrischen Spannung. Hierbei ist es vorteilhaft, wenn die Messschaltung von dem Widerstand thermisch und mechanisch entkoppelt ist.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert. Es zeigen:
- Figur 1: eine perspektivische Explosionsdarstellung eines erfindungsgemäßen Strommesswiderstands,
- Figur 1a: ein abgewandeltes Ausführungsbeispiel des Widerstandselementes mit aufgelöteten/aufgeschweißten Anschlussteilen aus Kupfer,
- Figur 2: ein anderes Ausführungsbeispiel eines erfindungsgemäßen Strommesswiderstands mit einem Folienträger mit darauf befindlichen Leiterbahnen zur konstruktiven Gestaltung der Spannungsabgriffe,
- Figur 3: den Strommesswiderstand aus Figur 2 ohne den Folienträger, sowie
- Figur 4: den Folienträger aus Figur 2 ohne den Strommesswiderstand.

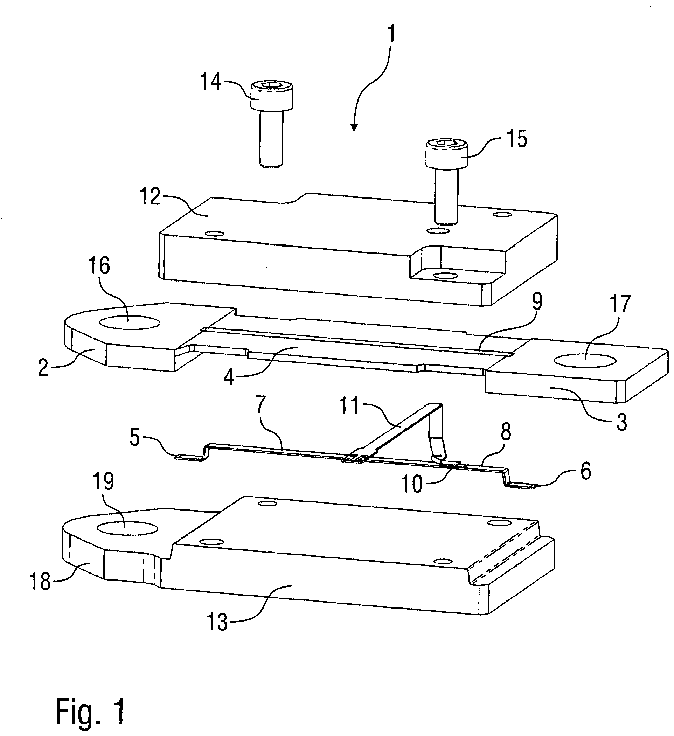

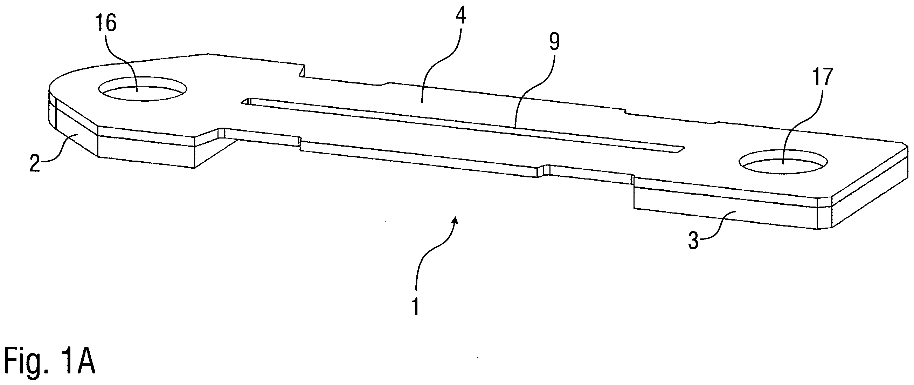

Im Folgenden wird nun unter Bezugnahme auf die Explosionsdarstellung in Figur 1 ein bevorzugtes Ausführungsbeispiel eines erfindungsgemäßen Strommesswiderstands 1 beschrieben.

Der Strommesswiderstand 1 weist zwei plattenförmige Anschlussteile 2, 3 auf, um den zu messenden elektrischen Strom in den Strommesswiderstand 1 einzuleiten bzw. von dem Strommesswiderstand 1 abzuführen. Die beiden plattenförmigen Anschlussteile 2, 3 bestehen in diesem Ausführungsbeispiel aus Kupfer, um Spannungsabfälle innerhalb der Anschlussteile 2, 3 zu vermeiden.

Es ist aber auch eine Ausführung der Anschlussteile 2, 3 in der Form denkbar, dass Cu-Plättchen oder Plättchen eines anderen leitfähigen Materials flächig auf das entsprechend verlängerte Widerstandmaterial aufgelötet oder geschweißt sind, was in Figur 1A dargestellt ist.

Zwischen die beiden Anschlussteile 2, 3 ist ein niederohmiges plattenförmiges Widerstandselement aus Nickel-Chrom oder Kupfer-Nickel eingesetzt, wobei das Widerstandselement 4 durch eine Verschweißung (bevorzugt Elektronenstrahlverschweißung) mit den beiden Anschlussteilen 2, 3 verbunden ist.

Bei einer Strommessung fließt der zu messende elektrische Strom also durch das Widerstandselement 4, so dass der Spannungsabfall über dem Widerstandselement 4 entsprechend dem Ohmschen Gesetz ein Maß für den zu messenden elektrischen Strom bildet. Zur Messung dieses Spannungsabfalls sind zwei Spannungsabgriffe 5, 6 vorgesehen, wobei der Spannungsabgriff 5 physisch und elektrisch mit dem Anschlussteil 2 verbunden ist, während der Spannungsabgriff 6 physisch und elektrisch mit dem anderen Anschlussteil 3 verbunden ist. An die beiden Spannungsabgriffe 5, 6 sind zwei Messleitungen 7, 8 angeschlossen, die als Flexleiter ausgebildet sind und in einer Nut 9 in dem Widerstandselement 4 von den außen liegenden Anschlussteilen 2, 3 nach innen zu einem Verbindungspunkt 10 und dann in einem gemeinsamen Kabelstrang 11 durch ein Loch im oberen Wärmesenkenbauteil 12 nach außen geführt sind, um die über dem Widerstandselement 4 abfallende elektrische Spannung messbar zu machen.

Darüber hinaus weist der Strommesswiderstand 1 zwei Wärmesenkenbauteile 12, 13 auf, die aus Aluminium mit einer eloxierten Oberflächenoxidschicht bestehen, wobei die beiden Wärmesenkenbauteile 12, 13 das Widerstandselement 4 an seiner Oberseite bzw. an seiner Unterseite vollflächig thermisch und physisch kontaktieren, um einen möglichst guten Wärmeübergang von dem Widerstandselement 4 auf die beiden Wärmesenkenbauteile 12, 13 zu erreichen. Zur Verbesserung des Wärmeübergangs ist zwischen dem Widerstandselement 4 und den beiden Wärmesenkenbauteilen 12, 13 eine Wärmeleitpaste angebracht. Bei der Montage werden die beiden Wärmesenkenbauteile 12, 13 durch Schrauben 14, 15 zusammengeschraubt.

Ferner ist noch zu erwähnen, dass sich in den beiden Anschlussteilen 2, 3 jeweils eine Anschlussbohrung 16, 17 befindet, um beispielsweise eine Stromklemme anschließen zu können.

In diesem Ausführungsbeispiel weist das Wärmesenkenbauteil 13 eine Zunge 18 auf, die seitlich in Deckung mit dem Anschlussteil 2 liegt und ebenfalls eine Anschlussbohrung 19 aufweist, wobei die beiden Anschlussbohrungen 16, 19 fluchten.

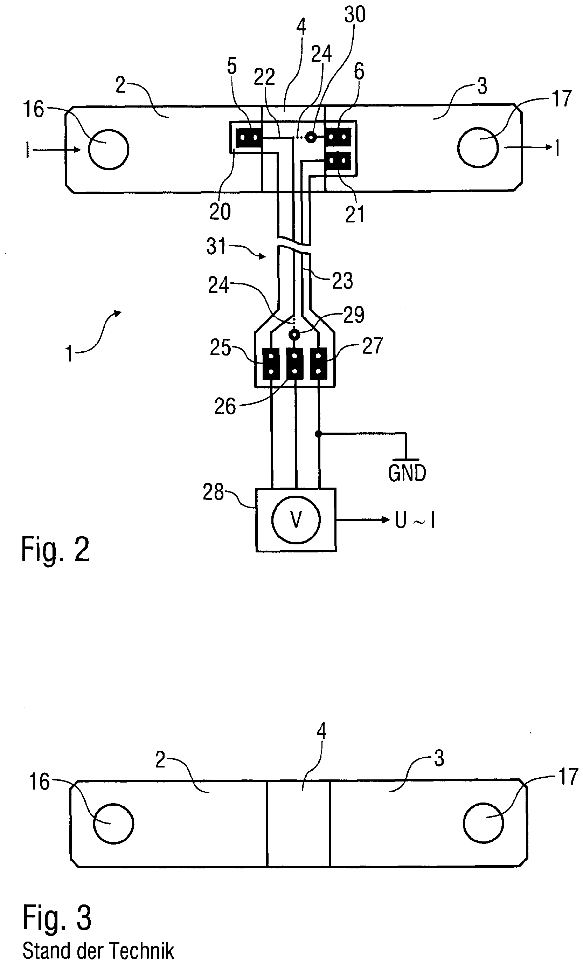

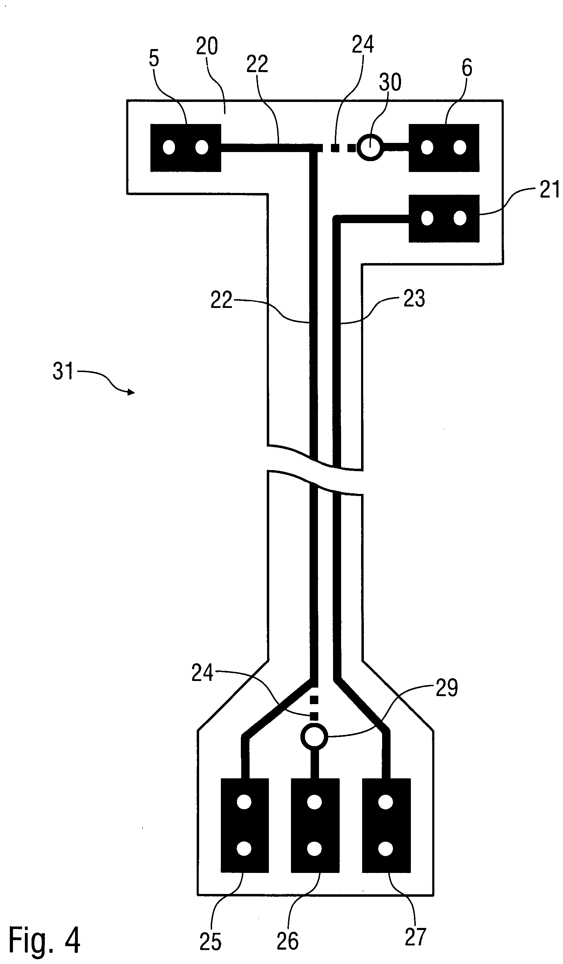

Die Figuren 2 bis 4 zeigen ein weiteres Ausführungsbeispiel eines erfindungsgemäßen Strommesswiderstands 1, wobei dieses Ausführungsbeispiel teilweise mit dem vorstehend beschriebenen Ausführungsbeispiel übereinstimmt, so dass zur Vermeidung von Wiederholungen auf die vorstehende Beschreibung verwiesen wird, wobei für entsprechende Einzelheiten dieselben Bezugszeichen verwendet werden.

Eine Besonderheit dieses Ausführungsbeispiels besteht in der konstruktiven Gestaltung der Spannungsabgriffe 5, 6 zur Kontaktierung der Anschlussteile 2, 3 des Strommesswiderstands 1. So sind die beiden Spannungsabgriffe 5, 6 als Kontaktierungsflächen beidseitig auf einem Folienträger 20 angebracht. Die Anschlussflächen sind dabei so positioniert, dass die Innenkanten mit der Stoßlinie zwischen Anschlussteilen und Widerstandselement übereinstimmen. Darüber hinaus befindet sich auf dem Folienträger 20 beidseitig noch eine weitere Kontaktierungsfläche 21, die einen Massekontakt bilden soll.

Zur Verbesserung der mechanischen Stabilität und der Lötbarkeit der Kontaktflächen können die Spannungsabgriffe 5, 6 und die Kontaktierungsflächen 21 für den Massekontakt und die Kontaktierungsflächen 25-27 für die Kontaktierung zu der Messschaltung 28 jeweils Bohrungen aufweisen, die durch den Folienträger 20 hindurchgehen und Verbindungen zu den auf der Oberseite liegenden Leiterflächen herstellen. Alle restlichen Leiterbahnen und Durchkontaktierungen sind durch eine Lack- oder Folienbeschichtung elektrisch isoliert und vor Benetzung mit Lot geschützt.

Darüber hinaus befinden sich auf dem Folienträger 20 Leiterbahnen 22-24, welche die Spannungsabgriffe 5, 6 und die Kontaktierungsfläche 21 mit entsprechenden Kontaktierungsflächen 25-27 verbinden, wobei sich die Kontaktierungsflächen 25-27 am gegenüberliegenden Ende des Folienträgers 20 befinden und einen Anschluss einer Messschaltung 28 ermöglichen.

Die Leiterbahnen 22-24 sind jeweils auf beiden Seiten mit Lack oder einer Folie elektrisch isoliert.

Die Kontaktierungsflächen 25-27 befinden sich hierbei auf derselben Seite des Folienträgers 20, wohingegen sich die Leiterbahnen 22, 23 einerseits und die Leiterbahn 24 andererseits auf gegenüberliegenden Seiten des Folienträgers 20 befinden. Der Folienträger 20 weist deshalb Durchkontaktierungen 29, 30 auf, um eine elektrische Verbindung von der Vorderseite zur Rückseite des Folienträgers 20 herzustellen.

Der Folienträger 20 bildet also mit den Spannungsabgriffen 5, 6 und den Kontaktierungsflächen 21, 25-27 und den Leiterbahnen 22-24 ein einheitliches Bauteil 31, das eine Spannungsmessung an dem Strommesswiderstand 1 ermöglicht.

Darüber hinaus ermöglicht das Bauteil 31 eine mechanische und thermische Entkopplung zwischen dem Strommesswiderstand 1 einerseits und der Messschaltung 28 andererseits.

Ein weiterer Vorteil des Bauteils 31 besteht darin, dass die von den Leiterbahnen 22, 24 aufgespannte Leiterschleife zwischen den Spannungsabgriffen 5, 6 eine äußerst geringe Fläche aufspannt, insbesondere dann, wenn die auf gegenüber liegenden Seiten des Folienträgers 20 geführten Leitungen 22 und 24 deckungsgleich (in der sogenannten Streifenleiteranordnung) verlaufen, so dass die gesamte Messanordnung gegenüber Störstrahlung wesentlich weniger empfindlich ist.

### Bezugszeichenliste:

- 1: Strommesswiderstand
- 2, 3: Anschlussteile
- 4: Widerstandselement
- 5, 6: Spannungsabgriffe
- 7, 8: Messleitungen
- 9: Nut
- 10: Verbindungspunkt
- 11: Kabelstrang
- 12, 13: Wärmesenkenbauteile
- 14, 15: Schrauben
- 16, 17: Anschlussbohrung
- 18: Zunge
- 19: Anschlussbohrung
- 20: Folienträger
- 21: Kontaktierungsfläche
- 22: Leiterbahn
- 23: Leiterbahn
- 24: Leiterbahn
- 25: Kontaktierungsfläche
- 26: Kontaktierungsfläche
- 27: Kontaktierungsfläche
- 28: Messschaltung
- 29: Durchkontaktierung
- 30: Durchkontaktierung
- 31: Bauteil

## Patentansprüche

1. Widerstand (1) mit
a) einem ersten Anschlussteil (2) aus einem elektrisch leitfähigen Leitermaterial zum Einleiten eines elektrischen Stroms (I) in den Widerstand (1),
b) einem zweiten Anschlussteil (3) aus einem elektrisch leitfähigen Leitermaterial zum Abführen des elektrischen Stroms (I) aus dem Widerstand (1),
c) einem Widerstandselement (4),
c1) das aus einem niederohmigen Widerstandsmaterial besteht, dessen spezifischer elektrischer Widerstand größer ist als der spezifische elektrische Widerstand des Leitermaterials der beiden Anschlussteile (2, 3), und
c2) das elektrisch zwischen dem ersten Anschlussteil (2) und dem zweiten Anschlussteil (3) angeordnet ist, so dass der elektrische Strom (I) durch das Widerstandselement (4) fließt,
d) einem ersten Spannungsabgriff (5) an dem ersten Anschlussteil (2) zur Messung der über dem Widerstandselement (4) abfallenden Spannung,
e) einem zweiten Spannungsabgriff (6) an dem zweiten Anschlussteil zur Messung der über dem Widerstandselement (4) abfallenden Spannung,
f) einer ersten Messleitung (22), die elektrisch mit dem ersten Spannungsabgriff (5) verbunden ist, und
g) einer zweiten Messleitung (24), die elektrisch mit dem zweiten Spannungsabgriff (6) verbunden ist,
h) wobei die beiden Messleitungen (7, 8) von den außen liegenden Spannungsabgriffen (5, 6) jeweils zunächst im Wesentlichen parallel zur Stromflussrichtung in dem Widerstandselement (4) nach innen zu einem Verbindungsbereich (10) geführt sind,
**dadurch gekennzeichnet,**
i) dass die beiden Messleitungen (7, 8) von dem Verbindungsbereich (10) ausgehend in einem gemeinsamen Kabelstrang (11) nach außen geführt sind,
j) dass der gemeinsame Kabelstrang (11) von dem Verbindungsbereich (10) ausgehend quer zur Stromflussrichtung in dem Widerstandselement (4) verläuft,
k) dass die Messleitungen (22, 24) als Leiterbahnen auf einem Folienträger (20) ausgebildet sind,
l) dass der Folienträger (20) auch Kontaktierungsflächen (5, 6, 25, 26) trägt zur elektrischen Kontaktierung der beiden Anschlussteile (2, 3), wobei die Messleitungen (22, 24) mit den Kontaktierungsflächen (25, 26) verbunden sind, und
m) dass die erste Messleitung (22) und die zweite Messleitung (24) auf gegenüberliegenden Seiten des Folienträgers (20) angeordnet sind.

2. Widerstand nach Anspruch 1, **dadurch gekennzeichnet, dass** eine Masseleitung (23) als Leiterbahn auf dem Folienträger (20) ausgebildet ist, wobei die Masseleitung (23) entweder das erste Anschlussteil (2) oder das zweite Anschlussteil (3) elektrisch kontaktiert.

3. Widerstand (1) nach einem der vorhergehenden Ansprüche, **dadurch gekennzeichnet, dass** die beiden Messleitungen (22, 24; 7, 8) eine Leiterschleife bilden, die eine Fläche von weniger als 5cm², 3cm², 2cm² oder 1cm² aufspannt.

4. Widerstand (1) nach einem der vorhergehenden Ansprüche, **dadurch gekennzeichnet, dass** die beiden Messleitungen (7, 8) und/oder der gemeinsame Kabelstrang (11) mit den beiden Messleitungen auf der Oberfläche des Widerstandselements (4) befestigt ist und/oder parallel zur Oberfläche des Widerstandselements (4) verläuft.

5. Widerstand (1) nach einem der vorhergehenden Ansprüche, **dadurch gekennzeichnet,**
a) **dass** die beiden Spannungsabgriffe (5, 6) die Anschlussteile (2, 3) jeweils direkt an der Kante zu dem Widerstandselement (4) kontaktieren, und/oder
b) **dass** die Anschlussteile (2, 3) zwei parallel zur Stromflussrichtung in dem Widerstand (1) verlaufende Seitenkanten aufweisen und die beiden Spannungsabgriffe (5, 6) jeweils mittig zwischen den beiden Seitenkanten angeordnet sind.

6. Widerstand (1) nach einem der vorhergehenden Ansprüche, **dadurch gekennzeichnet, dass** die beiden Spannungsabgriffe (5, 6) durch
a) eine Lötverbindung, insbesondere eine Reflow-LötVerbindung, oder
b) eine Schweißverbindung, oder
c) eine Klebeverbindung
mit den Anschlussteilen (2, 3) verbunden sind.

7. Widerstand (1) nach einem der vorhergehenden Ansprüche, **gekennzeichnet durch** eine elektrisch von dem Widerstandselement (4) isolierte Wärmesenke (12, 13), die thermisch und physisch mit dem Widerstandselement (4) verbunden ist und die in dem Widerstandselement (4) entstehende elektrische Verlustwärme mindestens teilweise aufnimmt und abführt.

8. Widerstand (1) nach Anspruch 7,
**dadurch gekennzeichnet,**
a) **dass** die Wärmesenke (12, 13) aus einem Wärmesenkenmaterial besteht, das eine größere spezifische Wärmekapazität aufweist als das Leitermaterial und/oder das Widerstandsmaterial, und/oder
b) **dass** das Wärmesenkenmaterial eine spezifische Wärmekapazität von mehr als 400 J/kg·K, 600 J/kg·K oder 800 J/kg·K aufweist, und/oder
c) **dass** die Wärmesenke (12, 13) eine wesentlich größere Wärmekapazität aufweist als das Widerstandselement (4), und/oder
d) **dass** die Wärmekapazität der Wärmesenke (12, 13) um einen Faktor von mindestens 10, 20 oder 30 größer ist als die Wärmekapazität des Widerstandselements (4), und/oder
e) **dass** die Wärmesenke (12, 13) ein wesentlich größeres Bauvolumen und/oder eine wesentlich größere Masse aufweist als das Widerstandselement (4), und/oder
f) **dass** das Wärmesenkenmaterial eine spezifische Wärmeleitfähigkeit von mehr als 100 W/m·K, 150 W/m·K oder 200 W/m·K aufweist, und/oder
g) **dass** die Wärmesenke (12, 13) aus Aluminium oder einer Aluminiumlegierung oder einem Aluminium-Kupfer plattierten Material besteht.

9. Widerstand (1) nach einem der Ansprüche 7 bis 8,
**dadurch gekennzeichnet,**
a) **dass** die Wärmesenke (12, 13) ein Oberteil (12) und ein Unterteil (13) aufweist, die das Widerstandselement (4) oben bzw. unten thermisch und physisch kontaktieren, und/oder
b) **dass** die Wärmesenke (12, 13) das Widerstandselement (4) oben und unten auf seiner gesamten Fläche berührt.

10. Widerstand (1) nach einem der Ansprüche 7 bis 9,
**dadurch gekennzeichnet,**
a) **dass** die Wärmesenke (12, 13) aus einem elektrisch leitfähigen Material besteht, insbesondere aus Aluminium oder einer Aluminiumlegierung, und
b) **dass** die Wärmesenke (12, 13) eine elektrisch isolierende Oberflächenschicht aufweist, insbesondere eine eloxierte Oxidschicht.

11. Widerstand (1) nach einem der Ansprüche 7 bis 10,
**dadurch gekennzeichnet,**
a) **dass** zwischen der Wärmesenke (12, 13) und dem Widerstandselement (4) ein Wärmeleitmittel angeordnet ist, insbesondere eine Wärmeleitpaste oder eine dünne Keramikschicht, und/oder
b) **dass** das Widerstandselement (4) in der Mitte zwischen den beiden Anschlussteilen (2, 3) einen größeren Stromflussquerschnitt aufweist als außen an den Kontaktstellen zu den Anschlussteilen (2, 3), und/oder
c) **dass** das Widerstandselement (4) wesentlich dünner ist als die Anschlussteile (2, 3).

12. Widerstand (1) nach einem der Ansprüche 7 bis 11,
**dadurch gekennzeichnet,**
a) **dass** die Wärmesenke (12, 13) und zumindest eines der beiden Anschlussteile (2, 3) in einem Bereich in Deckung übereinander liegen, und/oder
b) **dass** die Wärmesenke (12, 13) eine Anschlussbohrung (19) aufweist, und/oder
c) **dass** zumindest eines der Anschlussteile (2, 3) eine Anschlussbohrung (16, 17) aufweist, die mit der Anschlussbohrung (19) in der Wärmesenke (12, 13) fluchtet.

13. Messanordnung zur Strommessung mit
a) einem Widerstand (1) nach einem der vorhergehenden Ansprüche und
b) einer Messschaltung (28) zur Messung der über dem Widerstand (1) abfallenden elektrischen Spannung,
c) wobei die Messschaltung (28) mit den beiden Messleitungen (22, 24) des Widerstands (1) verbunden ist.

14. Messanordnung nach Anspruch 13,
**dadurch gekennzeichnet,**
a) **dass** die Messschaltung (28) von dem Widerstand (1) mechanisch entkoppelt ist, und/oder
b) **dass** die Messschaltung (28) von dem Widerstand (1) thermisch entkoppelt ist.

## Claims

1. Resistor (1) with
a) a first connecting part (2) made of an electrically conductive conductor material for introducing an electric current (I) into the resistor (1),
b) a second connecting part (3) made of an electrically conductive conductor material for discharging the electric current (I) from the resistor (1),
c) a resistor element (4),
c1) which consists of a low-ohmic resistance material whose specific electrical resistance is greater than the specific electrical resistance of the conductor material of the two connecting parts (2, 3), and
c2) which is electrically disposed between said first connecting part (2) and said second connecting part (3) so that said electric current (I) flows through said resistor element (4),
d) a first voltage tap (5) on the first connecting part (2) for measuring the voltage falling across the resistor element (4),
e) a second voltage tap (6) on the second connecting part for measuring the voltage falling across the resistor element (4),
f) a first measuring line (22) which is electrically connected to the first voltage tap (5), and
g) a second measuring line (24) which is electrically connected to the second voltage tap (6),
h) wherein the two measuring lines (7, 8) from the voltage taps (5, 6) lying on the outside are each first led essentially parallel to the current flow direction in the resistor element (4) inwards to a connection region (10),
**characterized in**
i) that the two measuring lines (7, 8), starting from the connection region (10), are routed outwards in a common cable strand (11),
j) that, starting from the connection region (10), the common cable strand (11) extends transversely to the current flow direction in the resistor element (4),
k) that the measuring lines (22, 24) are formed as conductor tracks on a foil carrier (20),
1) that the foil carrier (20) also carries contact areas (5, 6, 25, 26) for making electrical contact with the two connecting parts (2, 3), the measuring lines (22, 24) being connected to the contact areas (25, 26), and
m) that the first measuring line (22) and the second measuring line (24) are arranged on opposite sides of the foil carrier (20).

2. Resistor according to claim 1, **characterized in that** a ground line (23) is formed as a conductor track on the foil carrier (20), the ground line (23) electrically contacting either the first connecting part (2) or the second connecting part (3).

3. Resistor (1) according to one of the preceding claims, **characterized in that** the two measuring lines (22, 24; 7, 8) form a conductor loop which spans an area of less than 5cm², 3cm², 2cm² or 1cm².

4. Resistor (1) according to one of the preceding claims, **characterized in that** the two measuring lines (7, 8) and/or the common cable strand (11) with the two measuring lines is fixed on the surface of the resistor element (4) and/or runs parallel to the surface of the resistor element (4).

5. Resistor (1) according to one of the preceding claims, **characterized in**
a) **that** the two voltage taps (5, 6) contact the connecting parts (2, 3) in each case directly at the edge to the resistor element (4), and/or
b) **that** the connecting parts (2, 3) have two lateral edges running parallel to the current flow direction in the resistor (1) and the two voltage taps (5, 6) are in each case arranged centrally between the two lateral edges.

6. Resistor (1) according to one of the preceding claims, **characterized in that** the two voltage taps (5, 6) are connected to the connecting parts (2, 3) by
a) a soldered joint, in particular a reflow soldered joint, or
b) a welded joint, or
c) an adhesive joint.

7. Resistor (1) according to one of the preceding claims, **characterized by** a heat sink (12, 13) which is electrically insulated from the resistor element (4), which is thermally and physically connected to the resistor element (4) and at least partially absorbs and dissipates the electrical heat loss produced in the resistor element (4).

8. Resistor (1) according to claim 7, **characterized in**
a) **that** the heat sink (12, 13) consists of a heat sink material which has a greater specific heat capacity than the conductor material and/or the resistance material, and/or
b) **that** the heat sink material has a specific heat capacity exceeding 400 J/kg.K, 600 J/kg.K or 800 J/kg.K; and/or
c) **that** the heat sink (12, 13) has a substantially greater heat capacity than the resistor element (4), and/or
d) **that** the heat capacity of the heat sink (12, 13) is greater by a factor of at least 10, 20 or 30 than the heat capacity of the resistor element (4), and/or
e) **that** the heat sink (12, 13) has a substantially larger construction volume and/or a substantially larger mass than the resistor element (4), and/or
f) **that** the heat sink material has a specific thermal conductivity of more than 100 W/m·K, 150 W/m·K or 200 W/m·K, and/or
g) **that** the heat sink (12, 13) consists of aluminium or an aluminium alloy or an aluminium-copper-plated material.

9. Resistor (1) according to any of claims 7 to 8, **characterized in**
a) **that** the heat sink (12, 13) has an upper part (12) and a lower part (13) which thermally and physically contact the resistor element (4) at the top and bottom, respectively, and/or
b) **that** the heat sink (12, 13) contacts the resistor element (4) at the top and bottom over its entire surface.

10. Resistor (1) according to any one of claims 7 to 9, **characterized in**
a) **that** the heat sink (12, 13) consists of an electrically conductive material, in particular aluminium or an aluminium alloy, and
b) **that** the heat sink (12, 13) has an electrically insulating surface layer, in particular an anodized oxide layer.

11. Resistor (1) according to any of claims 7 to 10, **characterized in**
a) **that** between the heat sink (12, 13) and the resistor element (4) a heat-conducting means is arranged, in particular a heat-conducting paste or a thin ceramic layer, and/or
b) **that** the resistor element (4) has a larger current flow cross-section in the centre between the two connecting parts (2, 3) than on the outside at the contact points to the connecting parts (2, 3), and/or
c) **that** the resistor element (4) is substantially thinner than the connecting parts (2, 3).

12. Resistor (1) according to any one of claims 7 to 11, **characterized in**
a) **that** the heat sink (12, 13) and at least one of the two connecting parts (2, 3) lie in cover one above the other, and/or
b) **that** the heat sink (12, 13) has a connecting bore (19), and/or
c) **that** at least one of the connecting parts (2, 3) has a connecting bore (16, 17) which is aligned with the connecting bore (19) in the heat sink (12, 13).

13. Measuring arrangement for current measurement with
a) a resistor (1) according to one of the preceding claims; and
b) a measuring circuit (28) for measuring the electrical voltage falling across the resistor (1),
c) the measuring circuit (28) being connected to the two measuring lines (22, 24) of the resistor (1).

14. Measuring arrangement according to claim 13, **characterized in**
a) **that** the measuring circuit (28) is mechanically decoupled from the resistor (1), and/or
b) **that** the measuring circuit (28) is thermally decoupled from the resistor (1).

## Revendications

1. Résistance (1) comportant
a) un premier élément de raccordement (2) en matériau conducteur électriquement conductible pour l'induction d'un courant électrique (I) dans la résistance (1),
b) un second élément de raccordement (3) en matériau conducteur électriquement conductible pour l'évacuation du courant électrique (I) hors de la résistance (1),
c) un élément de résistance (4),
c1) qui se compose d'un matériau de résistance à basse valeur ohmique, dont la résistance électrique spécifique est plus grande que la résistance électrique spécifique du matériau conducteur des deux éléments de raccordement (2, 3), et
c2) qui est disposé électriquement entre le premier élément de raccordement (2) et le second élément de raccordement (3), de sorte que le courant électrique (I) circule à travers l'élément de résistance (4),
d) une première prise de tension (5) au niveau du premier élément de raccordement (2) pour la mesure de la tension chutant par l'intermédiaire de l'élément de résistance (4),
e) une seconde prise de tension (6) au niveau du second élément de raccordement pour la mesure de la tension chutant par l'intermédiaire de l'élément de résistance (4),
f) une première ligne de mesure (22) qui est reliée électriquement à la première prise de tension (5), et
g) une seconde ligne de mesure (24) qui est reliée électriquement à la seconde prise de tension (6),
h) dans laquelle les deux lignes de mesure (7, 8) sont guidées depuis les prises de tension (5, 6) se situant à l'extérieur respectivement d'abord sensiblement parallèlement à la direction de circulation du courant dans l'élément de résistance (4) vers l'intérieur jusqu'à une zone de liaison (10),
**caractérisée en ce que**
i) les deux lignes de mesure (7, 8) sont guidées vers l'extérieur depuis la zone de liaison (10) dans un faisceau de câblage commun (11),
j) le faisceau de câblage commun (11) s'étend depuis la zone de liaison (10) transversalement à la direction de circulation du courant dans l'élément de résistance (4),
k) les lignes de mesure (22, 24) sont réalisées en tant que pistes conductrices sur un support en forme de feuille (20),
l) le support en forme de feuille (20) supporte également des surfaces de contact (5, 6, 25, 26) pour un contact électrique des deux éléments de raccordement (2, 3), dans laquelle les lignes de mesure (22, 24) sont reliées aux surfaces de contact (25, 26), et
m) la première ligne de mesure (22) et la seconde ligne de mesure (24) sont disposées sur des faces opposées du support en forme de feuille (20).

2. Résistance selon la revendication 1, **caractérisée en ce qu'**une ligne de masse (23) est réalisée sur le support en forme de feuille (20) en tant que piste conductrice, dans laquelle la ligne de masse (23) établit un contact électrique soit avec le premier élément de raccordement (2) soit avec le second élément de raccordement (3).

3. Résistance (1) selon l'une des revendications précédentes, **caractérisée en ce que** les deux lignes de mesure (22, 24 ; 7, 8) forment une boucle conductrice qui couvre une surface de moins de 5 cm², 3 cm², 2 cm² ou 1 cm².

4. Résistance (1) selon l'une des revendications précédentes, **caractérisée en ce que** les deux lignes de mesure (7, 8) et/ou le faisceau de câblage commun (11) avec les deux lignes de mesure sont fixés sur la surface de l'élément de résistance (4) et/ou s'étendent parallèlement à la surface de l'élément de résistance (4) .

5. Résistance (1) selon l'une des revendications précédentes, **caractérisée en ce que**
a) les deux prises de tension (5, 6) établissent respectivement un contact direct au niveau de l'arête de l'élément de résistance (4) avec les éléments de raccordement (2, 3), et/ou
b) les éléments de raccordement (2, 3) présentent deux arêtes latérales s'étendant parallèlement à la direction de circulation du courant dans la résistance (1) et les deux prises de tension (5, 6) sont disposées respectivement au centre entre les deux arêtes latérales.

6. Résistance (1) selon l'une des revendications précédentes, **caractérisée en ce que** les deux prises de tension (5, 6) sont reliées aux éléments de raccordement (2, 3) par le biais
a) d'un brasage, en particulier un brasage par refusion, ou
b) d'une soudure, ou
c) d'un collage.

7. Résistance (1) selon l'une des revendications précédentes, **caractérisée par** un dissipateur thermique (12, 13) isolé électriquement de l'élément de résistance (4), qui est relié thermiquement et physiquement à l'élément de résistance (4) et qui absorbe et évacue au moins partiellement les pertes de chaleur électriques survenant dans l'élément de résistance (4).

8. Résistance (1) selon la revendication 7,
**caractérisée en ce que**
a) le dissipateur thermique (12, 13) se compose d'un matériau de dissipation thermique qui présente une capacité thermique spécifique plus grande que le matériau conducteur et/ou le matériau de résistance, et/ou
b) le matériau de dissipation thermique présente une capacité thermique spécifique de plus de 400 J/kg·K, 600 J/kg·K ou 800 J/kg·K, et/ou
c) le dissipateur thermique (12, 13) présente une capacité thermique sensiblement plus grande que l'élément de résistance (4), et/ou
d) la capacité thermique du dissipateur thermique (12, 13) est plus grande que la capacité thermique de l'élément de résistance (4) d'un facteur d'au moins 10, 20 ou 30, et/ou
e) le dissipateur thermique (12, 13) présente un volume de construction sensiblement plus grand et/ou une masse sensiblement plus grande que l'élément de résistance (4), et/ou
f) le matériau de dissipation thermique présente une capacité thermique spécifique de plus de 100 W/m·K, 150 W/m·K ou 200 W/m·K, et/ou
g) le dissipateur thermique (12, 13) se compose d'aluminium ou d'un alliage d'aluminium ou d'un matériau plaqué d'aluminium et de cuivre.

9. Résistance (1) selon l'une des revendications 7 et 8, **caractérisée en ce que**
a) le dissipateur thermique (12, 13) présente une partie supérieure (12) et une partie inférieure (13) qui établissent un contact thermique et physique respectivement par le haut et par le bas avec l'élément de résistance (4), et/ou
b) le dissipateur thermique (12, 13) touche l'élément de résistance (4) par le haut et le bas sur toute sa surface.

10. Résistance (1) selon l'une des revendications 7 à 9, **caractérisée en ce que**
a) le dissipateur thermique (12, 13) se compose d'un matériau électriquement conductible, en particulier en aluminium ou en alliage d'aluminium, et
b) le dissipateur thermique (12, 13) présente une couche de surface électriquement isolante, en particulier une couche d'oxyde anodisée.

11. Résistance (1) selon l'une des revendications 7 à 10, **caractérisée en ce que**
a) entre le dissipateur thermique (12, 13) et l'élément de résistance (4) est disposé un agent thermoconducteur, en particulier une pâte thermoconductrice ou une couche de céramique fine, et/ou
b) l'élément de résistance (4) présente au centre entre les deux éléments de raccordement (2, 3) une section de circulation du courant plus grande qu'à l'extérieur au niveau des points de contact des éléments de raccordement (2, 3), et/ou
c) l'élément de résistance (4) est sensiblement plus fin que les éléments de raccordement (2, 3).

12. Résistance (1) selon l'une des revendications 7 à 11, **caractérisée en ce que**
a) le dissipateur thermique (12, 13) et au moins l'un des éléments de raccordement (2, 3) se chevauchent dans une zone, et/ou
b) le dissipateur thermique (12, 13) présente un perçage de raccordement (19), et/ou
c) au moins l'un des éléments de raccordement (2, 3) présente un perçage de raccordement (16, 17) qui est aligné avec le perçage de raccordement (19) dans le dissipateur thermique (12, 13).

13. Dispositif de mesure pour la mesure du courant comportant
a) une résistance (1) selon l'une des revendications précédentes et
b) un circuit de mesure (28) pour la mesure de la tension électrique chutant par l'intermédiaire de la résistance (1),
c) dans lequel le circuit de mesure (28) est relié aux deux lignes de mesure (22, 24) de la résistance (1).

14. Dispositif de mesure selon la revendication 13, **caractérisé en ce que**
a) le circuit de mesure (28) est découplé mécaniquement de la résistance (1), et/ou
b) le circuit de mesure (28) est découplé thermiquement de la résistance (1).
